# EUROPÄISCHE PATENTSCHRIFT

(11) **EP 2 737 588 B1**
(45) Veröffentlichungstag und Bekanntmachung des Hinweises auf die Patenterteilung: **23.03.2016**
(21) Anmeldenummer: 12769951.0
(22) Anmeldetag: 05.09.2012
(51) Int. Cl.: H02H 7/26, H02H 3/087

(54) **GLEICHSPANNUNGS-LEITUNGSSCHUTZSCHALTER**
DC VOLTAGE CIRCUIT BREAKER
DISJONCTEUR DE PROTECTION DE CIRCUIT À TENSION CONTINUE

(30) Priorität: 29.09.2011 DE 102011083693
(43) Veröffentlichungstag der Anmeldung: 04.06.2014
(73) Patentinhaber: Siemens Aktiengesellschaft, 80333 München (DE)
(72) Erfinder: GAXIOLA, Enrique, F-13090 Aix-en-Provence (DE); VOGELSANG, Jakob, 90765 Fürth (DE)
(86) Internationale Anmeldenummer: PCT/EP2012/067276
(87) Internationale Veröffentlichungsnummer: WO 2013/045238

(56) Entgegenhaltungen:
- EP-A1- 0 431 510
- EP-A1- 0 758 137
- US-A- 5 666 257

## Beschreibung

Die vorliegende Erfindung betrifft einen Gleichspannungs-Leitungsschutzschalter.

Elektrische Energie wird in Kraftwerken in der Regel als Dreiphasenwechselstrom erzeugt. Zur Übertragung wird diese Energie durch Leistungstransformatoren auf sehr hohe elektrische Wechselspannungen transformiert und über Freileitungen übertragen. Bei sehr langen Freileitungen ist eine Übertragung der Energie mit Gleichstrom allerdings mit geringeren Verlusten verbunden und damit günstiger.

Bei der Gleichstromübertragung bestehen im Stand der Technik allerdings Schwierigkeiten, Leistungsflüsse in vermaschten Leitungsnetzen zu steuern. Daher werden zur Gleichstromübertragung bisher fast ausschließlich Punkt-zu-Punkt-Verbindungen ohne Abzweigungen oder Maschen verwendet. Für die Zukunft ist allerdings ein Auf- und Ausbau von Gleichstrom-Leitungsnetzen geplant. Hierzu sind Gleichspannungs-Leitungsschutzschalter erforderlich, um die Verfügbarkeit der geplanten Gleichstrom-Leitungsnetze zu erhöhen. Gleichspannungs-Leitungsschutzschalter dienen dazu, im Fehlerfall Teile eines Leitungsnetzes selektiv abzuschalten und dadurch einen Ausfall des gesamten Leitungsnetzes zu verhindern.

Aus der EP 0 431 510 A1 und EP 0 758 137 A1 sind Gleichspannungs-Leistungsschutzschalter bekannt, der zwei Unterbrecher sowie eine Pulsgeneratorschaltung aus Kondensator, Induktivität und Schalter umfasst. Der Leistungsschutzschalter umfasst weiterhin einen Energieabsorber, der die Schaltstrecke des Schutzschalters überbrückt. Ein weiterer Gleichspannungs-Leistungsschutzschalter ist aus der US 5 666 257 A bekannt.

Die Aufgabe der vorliegenden Erfindung ist es, einen verbesserten Gleichspannungs-Leitungsschutzschalter bereitzustellen. Diese Aufgabe wird durch einen Gleichspannungs-Leitungsschutzschalter mit den Merkmalen des Patentanspruchs 1 gelöst.

Der erfindungsgemäße Gleichspannungs-Leitungsschutzschalter umfasst einen ersten bis vierten Knoten, wobei
- zwischen dem ersten Knoten und dem vierten Knoten ein erster Unterbrecher angeordnet ist,
- zwischen dem vierten Knoten und dem dritten Knoten ein zweiter Unterbrecher angeordnet ist,
- zwischen dem vierten Knoten und dem zweiten Knoten eine Pulsgeneratorschaltung angeordnet ist, wobei die Pulsgeneratorschaltung eine Parallelschaltung von einem Kondensator zu einer Serienschaltung aus einer Induktivität und einem Schalter umfasst,
- zwischen dem dritten Knoten und dem zweiten Knoten ein erster Energieabsorber angeordnet ist.

Dabei kann zwischen dem ersten Knoten und dem zweiten Knoten eine erste Gleichspannung angelegt und zwischen dem dritten Knoten und dem zweiten Knoten eine zweite Gleichspannung abgegriffen werden. Der Schalter kann ein Halbleiterschalter sein, beispielsweise ein Bipolartransistor mit isolierter Gate-Elektrode (IGBT) oder ein Thyristor (three terminal Semi-Conductor Rectifier, SCR).

Für die Erfindung wurde erkannt, dass die Pulsgeneratorschaltung bei geeigneter Ansteuerung erlaubt, einen Stromnulldurchgang sehr schnell zu erzwingen. Dieser erzwungene Nulldurchgang erlaubt vorteilhafterweise ein Auftrennen der durch den Gleichspannungs-Leitungsschutzschalter gesicherten Leitung. Dies ermöglicht vorteilhafterweise eine Ausführung des Gleichspannungs-Leitungsschutzschalters mit einer geringen Zahl an Schaltelementen und verkürzt die maximal notwendige Zeit zur vollständigen Stromunterbrechung und selektiven Abschaltung eines Teils eines Leitungsnetzes.

Erfindungsgemäß ist eine Freilaufdiode in Serie zum ersten Energieabsorber angeordnet, um unter normalen Spannungsverhältnissen eine Trennung zwischen dem dritten Knoten und dem zweiten Knoten einzuhalten.

Bevorzugt umfasst die Pulsgeneratorschaltung in Serie zu der Parallelschaltung einen Widerstand und eine zweite Diode. Weiterhin umfasst die Pulsgeneratorschaltung bevorzugt parallel zu der Parallelschaltung und dem Widerstand einen zweiten Varistor.

Bevorzugt umfasst der Gleichspannungs-Leitungsschutzschalter eine Steuerungseinrichtung, die ausgestaltet ist, im Falle einer Abschaltung folgende Schritte vorzunehmen:
- Anschalten des Thyristors;
- Öffnen des zweiten Unterbrechers;
- Öffnen des ersten Unterbrechers.

In einer bevorzugten Ausführungsform des Gleichspannungs-Leitungsschutzschalters ist der erste Unterbrecher nur ein einfache Trenner oder alternativ ein SF6-Unterbrecher. Vorteilhafterweise eignen sich SF6-Unterbrecher zum Unterbrechen sehr großer Spannungen. Bevorzugt ist der zweite Unterbrecher ein hybrider Unterbrecher. Bevorzugt enthält der zweite Unterbrecher einen Vakuum-Unterbrecher. Vorteilhafterweise eignen sich Vakuum-Unterbrecher für große Schalthäufigkeiten und sind weitgehend wartungsfrei.

Die oben beschriebenen Eigenschaften, Merkmale und Vorteile dieser Erfindung, sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Dabei zeigen:
Figur 1 eine Schaltungsanordnung eines Gleichspannungs-Leitungsschutzschalters;
Figur 2 bis Figur 4 Diagramme zu Strom- und Spannungsverläufen bei Abschaltung eines Kurzschlusses;
Figur 5 eine Schaltungsanordnung eines bipolaren Gleichspannungs-Leitungsschutzschalters.

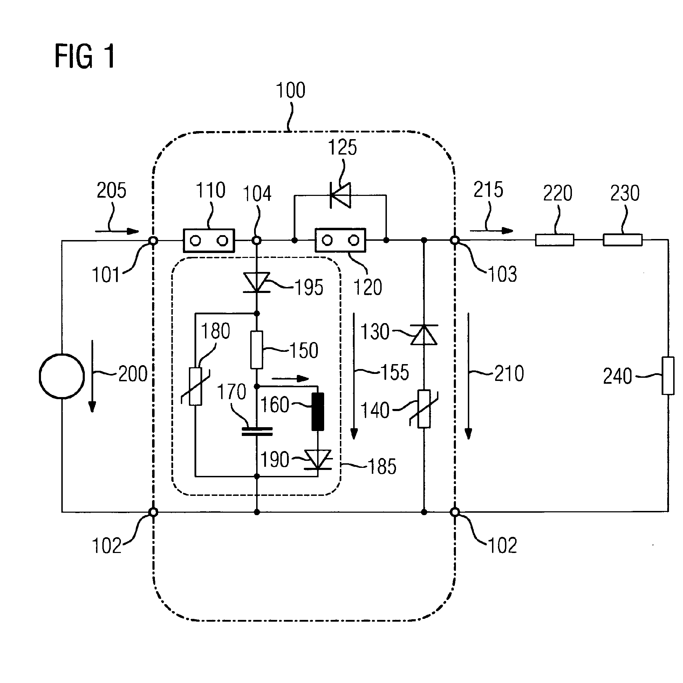

Figur 1 zeigt eine Schaltungsanordnung eines Gleichspannungs-Leitungsschutzschalters 100. Der Gleichspannungs-Leitungsschutzschalter kann in einem Gleichstrom-Leitungsnetz integriert werden, um im Falle eines Kurzschlusses einen Teil des Gleichstrom-Leitungsnetzes selektiv abzuschalten. Der Gleichspannungs-Leitungsschutzschalter 100 kann beispielsweise zur Verwendung in einem Hochspannungs-Gleichstrom-Leitungsnetz vorgesehen sein. Der Gleichspannungs-Leitungsschutzschalter 100 ermöglicht in einem Gleichstrom-Leitungsnetz einen Schutz der positiven Phase gegen das Erdpotential, der negativen Phase gegen das Erdpotential und der positiven Phase gegen die negative Phase.

Der Gleichspannungs-Leitungsschutzschalter 100 weist einen ersten bis vierten Knoten 101...104 auf. Die Knoten 101...104 sind Schaltungsknoten des Gleichspannungs-Leitungsschutzschalters 100, die sich jeweils auf einem elektrischen Potential befinden. Die Knoten 101...104 können demnach jeweils auch elektrische Leiterabschnitte umfassen, sofern die elektrischen Widerstände dieser Leiterabschnitte vernachlässigbar sind.

Zwischen dem ersten Knoten 101 und dem zweiten Knoten 102 des Gleichspannungs-Leitungsschutzschalters 100 kann eine Gleichspannung 200 angelegt werden. Die Gleichspannung 200 kann eine Quellenspannung sein, die durch einen Hochspannungsgleichrichter an ein Gleichstrom-Leitungsnetz angelegt wird. Der erste Knoten 101 und der zweite Knoten 102 bilden in diesem Fall eine Eingangsseite des Gleichspannungs-Leitungsschutzschalters 100 und des an den Gleichspannungs-Leitungsschutzschalter 100 anschließenden Gleichstrom-Leitungsnetzes. Die zwischen dem ersten Knoten 101 und dem zweiten Knoten 102 angelegte Gleichspannung 200 kann beispielsweise 500 kV betragen. Die Gleichspannung 200 kann jedoch auch höhere Spannungswerte von mehr als 1200 kV annehmen. Die Gleichspannung 200 kann in dem Gleichstrom-Leitungsnetz, in dem der Gleichspannungs-Leitungsschutzschalter 100 verwendet wird, einen Gleichstrom von 20 kA oder mehr anregen.

Zwischen dem dritten Knoten 103 und dem zweiten Knoten 102 des Gleichspannungs-Leitungsschutzschalters 100 kann eine Ausgangsspannung 210 abgegriffen werden. Die Ausgangsspannung 210 ist eine Gleichspannung und entspricht im Wesentlichen der zwischen dem ersten Knoten 101 und dem zweiten Knoten 102 angelegten Gleichspannung 200. Im Falle eines Kurzschlusses kann der Gleichspannungs-Leitungsschutzschalter 100 die Verbindung zwischen dem ersten Knoten 101 und dem dritten Knoten 103 jedoch auftrennen, so dass die Ausgangsspannung 210 nicht mehr der Gleichspannung 200 entspricht.

An dem dritten Knoten 103 und dem zweiten Knoten 102 können sich Leitungsteile des Gleichstrom-Leitungsnetzes anschließen, in dem der Gleichspannungs-Leitungsschutzschalter 100 verwendet wird. Diese Teile des Gleichstrom-Leitungsnetzes sind in Figur 1 schematisch durch eine Leitungsimpedanz 220, einen Leitungswiderstand 230 und einen Lastwiderstand 240 dargestellt.

Zwischen dem ersten Knoten 101 und dem vierten Knoten 104 ist ein Hilfs-Unterbrecher 110 angeordnet. Der Hilfs-Unterbrecher 110 dient dazu, im Falle eines Kurzschlusses eine elektrische Verbindung zwischen dem ersten Knoten 101 und dem vierten Knoten 104 aufzutrennen.

Zwischen dem vierten Knoten 104 und dem dritten Knoten 103 weist der Gleichspannungs-Leitungsschutzschalter 100 einen hybriden Unterbrecher 120 auf. Der hybride Unterbrecher 120 dient dazu, im Falle eines Kurzschlusses die elektrische Verbindung zwischen dem vierten Knoten 104 und dem dritten Knoten 103 aufzutrennen.

Der Hilfs-Unterbrecher 110 und der hybride Unterbrecher 120 können die elektrische Verbindung zwischen dem ersten Knoten 101 und dem dritten Knoten 103 nur auftrennen, wenn ein zwischen dem ersten Knoten 101 und dem dritten Knoten 103 fließender elektrischer Strom klein ist, sich also dem Wert null annähert. Andernfalls kommt es während des Auftrennens der Verbindung zwischen dem ersten Knoten 101 und dem dritten Knoten 103 zur nichtlöschbaren Ausbildung von Lichtbögen, die den Hilfs-Unterbrecher 110, den hybriden Unterbrecher 120, den gesamten Gleichspannungs-Leitungsschutzschalter 100 oder auch weitere Teile eines Gleichstrom-Leitungsnetzes beschädigen oder zerstören können. Somit muss im Falle eines Kurzschlusses der zwischen dem ersten Knoten 101 und dem dritten Knoten 103 fließende elektrische Strom binnen kürzester Zeit auf null abgesenkt werden, damit der Hilfs-Unterbrecher 110 und der hybride Unterbrecher 120 die elektrische Verbindung zwischen dem ersten Knoten 101 und dem dritten Knoten 103 unterbrechen können. Hierzu weist der Gleichspannungs-Leitungsschutzschalter 100 eine Pulsgeneratorschaltung 185 auf, die zwischen dem vierten Knoten 104 und dem zweiten Knoten 102 angeordnet ist.

Des Weiteren weist der Gleichspannungs-Leitungsschutzschalter 100 zwischen dem dritten Knoten 103 und dem zweiten Knoten 102 eine Serienschaltung aus einer Freilaufdiode 130 und einem Metalloxid-Varistor 140 auf. Die Freilaufdiode 130 ist sperrend gegenüber der üblicherweise positiven DC-Spannung beim dritten Knoten 103 angeordnet.

Die Pulsgeneratorschaltung 185 des Gleichspannungs-Leitungsschutzschalters 100 umfasst einen Widerstand 150, eine Spule 160, einen Kondensator 170, einen Thyristor 190 und einen zweiten Metalloxid-Varistor 180. Dabei bilden der Kondensator 170 einerseits und eine Serienschaltung aus der Spule 160 und dem Thyristor 190 eine Parallelschaltung. Diese ist ihrerseits in Reihe zum Widerstand 150 geschaltet. Die Serie aus Widerstand und der Parallelschaltung ist wiederum parallel zum zweiten Metalloxid-Varistor 180 angeordnet. Eine zweite Diode 195 ist den vorgenannten Elementen in Reihe zum vierten Knoten 104 hin vorgeschaltet. Die zweite Diode 195 ist dabei für die üblicherweise positive DC-Spannung beim vierten Knoten 140 leitend angeordnet.

Die Pulsgeneratorschaltung 185 dient dazu, einen elektrischen Gegenstrom durch den Vakuumunterbrecher 120 zu erzeugen, der dem gewöhnlichen Stromfluss durch den hybriden Unterbrecher 120 entgegen gerichtet ist und diesen kompensiert. Auf diese Weise bewirkt die Pulsgeneratorschaltung 185 einen Nulldurchgang des Stromflusses durch den hybriden Unterbrecher 120, der es dem hybriden Unterbrecher 120 ermöglicht, die elektrische Verbindung zwischen dem ersten Knoten 101 und dem vierten Knoten 104 zu unterbrechen, und damit auch die elektrische Verbindung zwischen dem ersten Knoten 101 und dem dritten Knoten 103 auftrennt.

Die Metalloxid-Varistoren 140, 180 dienen dazu, die im Fall eines Kurzschlusses und einer durch den Gleichspannungs-Leitungsschutzschalter 100 bewirkten Unterbrechung freiwerdende Energie 165 zu absorbieren.

Im gewöhnlichen Betrieb des Gleichspannungs-Leitungsschutzschalters 100 ist der Thyristor 190 des Gleichspannungs-Leitungsschutzschalters 100 geöffnet. Stromfluss zwischen dem ersten Knoten 101 und dem dritten Knoten 103 ist über den Hilfs-Unterbrecher 110 und den hybriden Unterbrecher 120 möglich. Kommt es im Gleichstrom-Leitungsnetz, in dem der Gleichspannungs-Leitungsschutzschalter 100 verwendet wird, zu einem Kurzschluss, so steigt der durch den Gleichspannungs-Leitungsschutzschalter 100 fließende elektrische Strom stark an. Dies wird durch eine in Figur 1 nicht dargestellte Detektionsvorrichtung detektiert. Wird ein übermäßiger Anstieg des im Gleichspannungs-Leitungsschutzschalter 100 fließenden elektrischen Stroms erkannt, so wird eine Abschaltung unternommen.

Im Folgenden wird ein beispielhaftes Ablaufschema angegeben:
- Erster Zeitabschnitt von 0 ms bis 0,5 ms: Das Netzwerk arbeitet normal.
- Zweiter Zeitabschnitt von 0,5 ms bis 1,6 ms: Ein Kurzschluss tritt im Netzwerk auf und der Strom steigt im Wesentlichen linear an, wobei die Steigung von der Leitungsimpedanz 220 abhängt.
- Dritter Zeitabschnitt von 1,6 ms bis 1,64 ms: Der Kurzschluss wird detektiert und bestätigt. Der hybride Unterbrecher 120 wird geöffnet. Der Thyristor 190 wird durch die Steuerung des Gleichspannungs-Leitungsschutzschalters 100 eingeschaltet. Daraufhin entlädt sich der Kondensator 170 über die Spule 160, was zu einer - gegenüber den Normalbedingungen im Gleichspannungs-Leitungsschutzschalter 100 - umgekehrten Spannung 155 über die Pulsgeneratorschaltung 185 führt. Da die Lichtbogenspannung gewöhnlich vergleichsweise niedrig ist (8 V bis 80 V), sind die Gleichspannung 200 und die Ausgangsspannung 210 anfänglich praktisch gleich groß. Die Spannung fällt in der Folge auf den Wert der Schwellspannung des Metalloxid-Varistors 140.
- Vierter Zeitabschnitt von 1,64 ms bis 1,68 ms: Ist die Schwellspannung des Metalloxid-Varistors 140 erreicht, kommutiert der Strom 157 durch die Pulsgeneratorschaltung 185 zum Metalloxid-Varistor 140 und zum hybriden Unterbrecher 120. Ist die Pulsgeneratorschaltung 185 geeignet ausgelegt, erfährt der Strom durch den hybriden Unterbrecher 120 einen Nulldurchgang, wodurch der Lichtbogen gelöscht wird und somit der Strom endgültig unterbrochen wird. Um den Nulldurchgang zu bewirken, muss der Spitzenwert des Stroms 157 durch die Pulsgeneratorschaltung 185 wenigstens dem anderweitig fließenden Strom durch den hybriden Unterbrecher 120 entsprechen. Der Quellstrom 205 lädt in der Folge den Kondensator 170 wieder bis zur Schwellspannung des zweiten Metalloxid-Varistors 180 auf.
- Fünfter Zeitabschnitt von 1,68 ms bis 4,9 ms: Die magnetisch gespeicherte Energie 165 wird im zweiten Metalloxid-Varistor 180 abgebaut und der Quellstrom 205 hat beim Zeitpunkt t5 einen Nulldurchgang und der Gleichspannungs-Leitungsschutzschalters 100 kann eine endgültige Trennung vornehmen, beispielsweise durch Öffnen des Hilfs-Unterbrechers 110. Wird der Leistungsschalter (100) an der Sammelschiene angeordnet, so muss der Hilfs-Unterbrecher 110 wesentlich kleineren Ansprüchen genügen. Sein Einsatz verhindert eine Oszillation von Kondensator 170 nach dem Abschaltvorgang. Zudem dient dieser dem Aufbau einer sicheren Trennstrecke. Die Zeitspanne, die zum Abbau der Energie 165 vergeht, hängt von den Eigenschaften der Varistoren 140, 180 ab. Eine höhere Abbaurate kann beispielsweise durch eine Parallelschaltung mehrerer Varistoren 140, 180 erreicht werden.

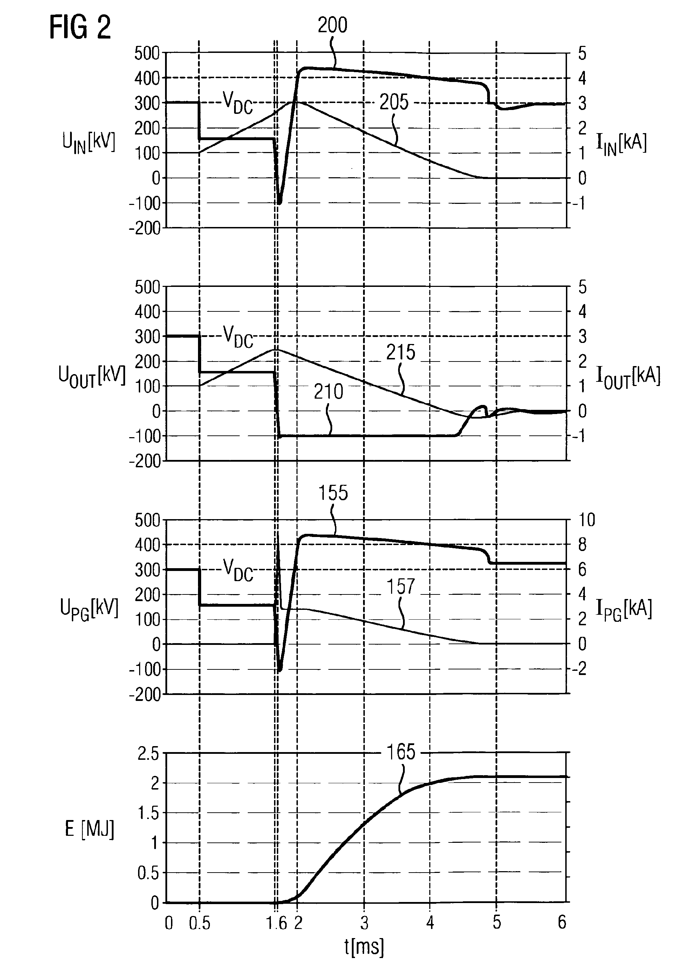

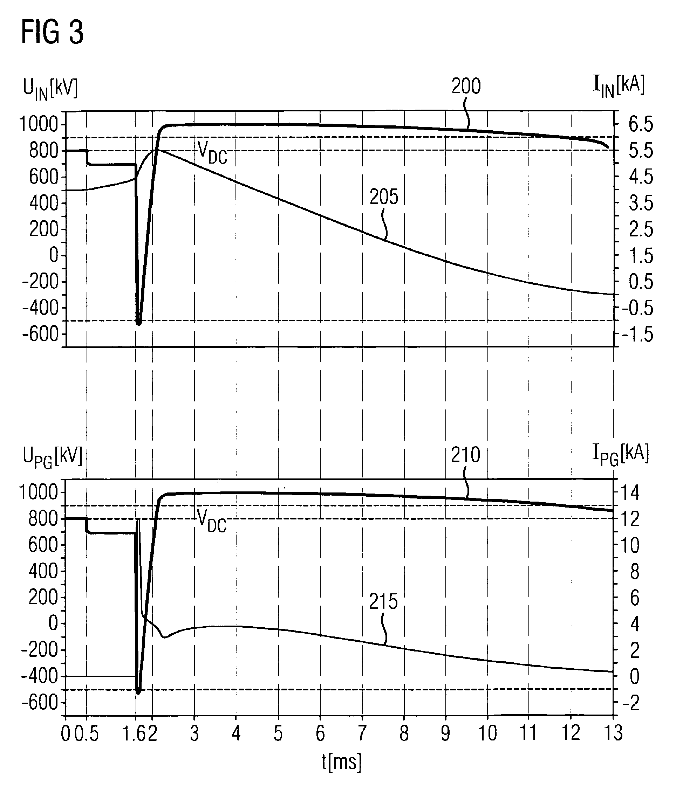

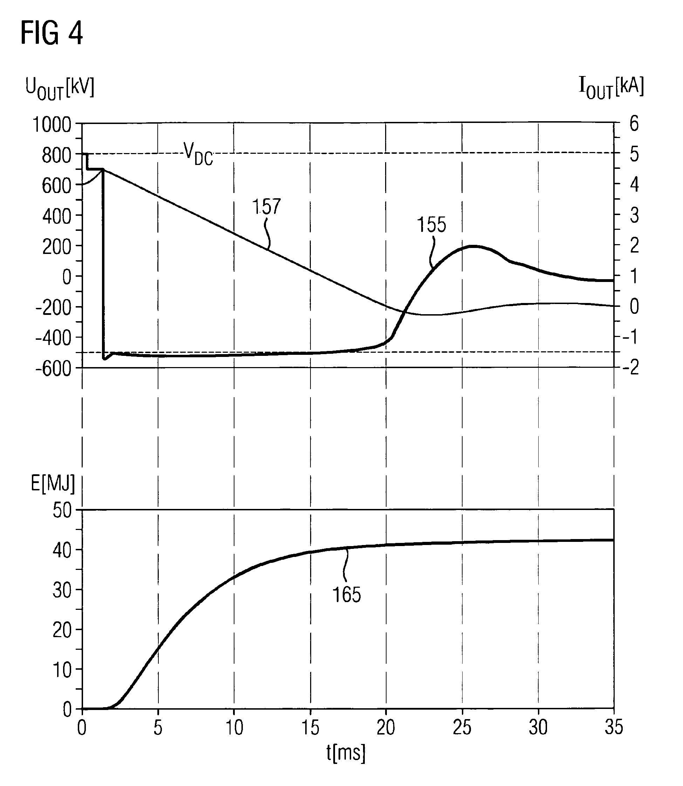

Die Figuren 2 bis 4 zeigen hierzu die Verläufe von Gleischspannung 200, Quellstrom 205, Ausgangsspannung 210 und Ausgangsstrom 215, Spannung 155 über die Pulsgeneratorschaltung 185 und Strom 157 durch die Pulsgeneratorschaltung 185 sowie die abgebaute Energie 165. Die in Figur 3 gezeigten Verläufe entstehen dabei bei einem angenommenen Kurzschluss in 1000 km Entfernung. Die Verläufe in Figur 4 entstehen bei einem angenommenen Kurzschluss in weniger als 1 km Entfernung.

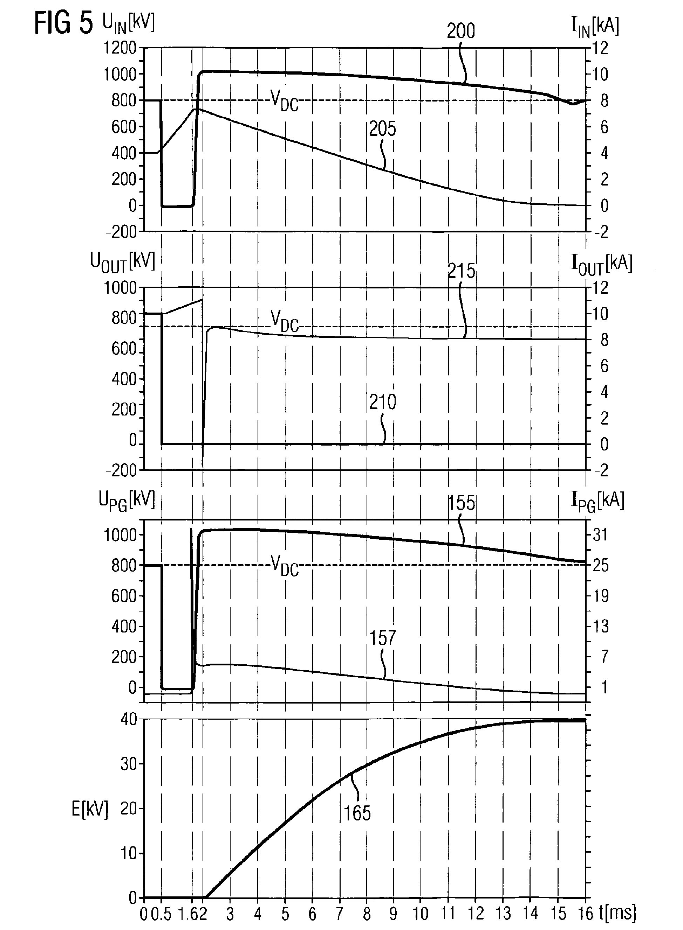

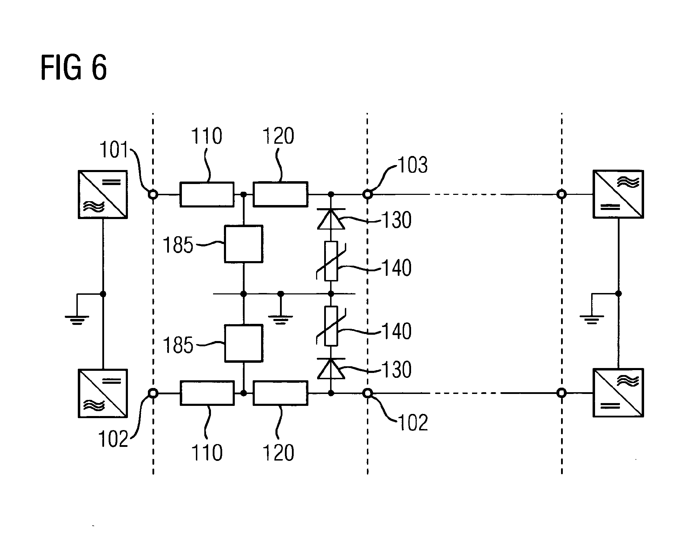

Figur 5 gibt stark schematisiert einen Aufbau für einen zweiten Gleichspannungs-Leitungsschutzschalter 300 wieder, der für symmetric monopole (und bipolare) Anwendungsfälle ausgestaltet ist. Dabei besteht der gesamte zweite Gleichspannungs-Leitungsschutzschalter 300 aus zwei Gleichspannungs-Leitungsschutzschaltern 100 gemäß Figur 1. Einer davon ist zwischen dem positiven Pol und Erdpotential und der zweite davon ist zwischen dem Erdpotential und dem negativen Pol angeordnet.

Der Gleichspannungs-Leitungsschutzschalter 100 ermöglicht eine physikalische Trennung in einem Gleichstrom-Leitungsnetz bei Energien 165 von bis zu 20 MJ in einer Zeit in der Größenordnung von 10 ms. Dies entspricht dem bei Wechselspannungs-Leitungsnetzen Üblichen. Der Gleichspannungs-Leitungsschutzschalter 100 erlaubt die Verwendung von Gleichstrom-Leitungsnetzen mit Maschen, also von Gleichstrom-Leitungsnetzen, die nicht nur lediglich eine Punkt-zu-Punkt-Verbindung umfassen. Der Gleichspannungs-Leitungsschutzschalter 100 ist besonders vorteilhaft für die Verwendung in Multi-Terminal-Off-Shore-Hochspannungs-Einspeisepunkten, die erneuerbare Energiequellen nutzen. Der Gleichspannungs-Leitungsschutzschalter 100 kann beispielsweise in Kombination mit Windkraftanlagen verwendet werden.

## Patentansprüche

1. Gleichspannungs-Leitungsschutzschalter (100) mit einem ersten Knoten (101), einem zweiten Knoten (102), einem dritten Knoten (103) und einem vierten Knoten (104), wobei
- das den ersten Knoten (101) und den zweiten Knoten (102) umfassende Knotenpaar als quellenseitiger Eingang vorgesehen ist,
- das den dritten Knoten (103) und den zweiten Knoten (102) umfassende Knotenpaar als lastseitiger Ausgang vorgesehen ist,
- zwischen dem ersten Knoten (101) und dem vierten Knoten (104) ein erster Unterbrecher (110) angeordnet ist,
- zwischen dem vierten Knoten (104) und dem dritten Knoten (103) ein zweiter Unterbrecher (120) angeordnet ist,
- zwischen dem vierten Knoten (101) und dem zweiten Knoten (102) eine Pulsgeneratorschaltung (185) angeordnet ist, wobei die Pulsgeneratorschaltung (185) eine Parallelschaltung von einem Kondensator (170) zu einer Serienschaltung aus einer Induktivität (160) und einem Schalter (190) umfasst,
**dadurch gekennzeichnet, dass**
zwischen dem dritten Knoten (103) und dem zweiten Knoten (102) eine Freilaufdiode (130) in Serie mit einem ersten Energieabsorber (140) angeordnet ist.

2. Gleichspannungs-Leitungsschutzschalter (100) gemäß Anspruch 1, bei dem die Pulsgeneratorschaltung (185) in Serie zu der Parallelschaltung einen Widerstand (150) und eine zweite Diode (195) umfasst.

3. Gleichspannungs-Leitungsschutzschalter (100) gemäß einem der vorangehenden Ansprüche, bei dem die Pulsgeneratorschaltung (185) parallel zu der Parallelschaltung und dem Widerstand einen zweiten Energieabsorber (180) umfasst.

4. Gleichspannungs-Leitungsschutzschalter (100) gemäß einem der vorhergehenden Ansprüche, bei dem der erste Unterbrecher (110) ein einfacher Trenner oder ein SF6-Unterbrecher ist.

5. Gleichspannungs-Leitungsschutzschalter (100) gemäß einem der vorhergehenden Ansprüche, bei dem der zweite Unterbrecher (120) ein hybrider Unterbrecher ist, der bevorzugt einen Vakuum-Unterbrecher enthält.

## Claims

1. DC voltage circuit breaker (100) having a first node (101), a second node (102), a third node (103), and a fourth node (104), wherein
- the node pair comprising the first node (101) and the second node (102) is provided as a source-side input,
- the node pair comprising the third node (103) and the second node (102) is provided as a load-side output,
- a first interrupter (110) is situated between the first node (101) and the fourth node (104),
- a second interrupter (120) is situated between the fourth node (104) and the third node (103),
- a pulse generator circuit (185) is situated between the fourth node (101) and the second node (102), the pulse generator circuit (185) comprising a parallel connection of a capacitor (170) with a series circuit made up of an inductor (160) and a switch (190),
**characterized in that** a flyback diode (130) is situated in series with a first energy absorber (140) between the third node (103) and the second node (102).

2. DC voltage circuit breaker (100) according to Claim 1, in which the pulse generator circuit (185) comprises a resistor 150) and a second diode (195) in series with the parallel circuit.

3. DC voltage circuit breaker (100) according to one of the preceding claims, in which the pulse generator circuit (185) comprises a second energy absorber (180) in parallel with the parallel circuit and the resistor.

4. DC voltage circuit breaker (100) according to one of the preceding claims, in which the first interrupter (110) is a simple disconnector or an SF6 interrupter.

5. DC voltage circuit breaker (100) according to one of the preceding claims, in which the second interrupter (120) is a hybrid interrupter that preferably contains a vacuum interrupter.

## Revendications

1. Disjoncteur (100) de protection de circuit à tension continue, comprenant un premier noeud (101), un deuxième noeud (102) un troisième noeud (103) et un quatrième noeud (104), dans lequel
- la paire de noeuds comprenant le premier noeud (101) et le deuxième (102) est prévue comme entrée du côté source,
- la paire de noeuds comprenant le troisième noeud (103) et le deuxième noeud (102) est prévue comme sortie du côté charge,
- un premier interrupteur (110) est monté entre le premier (101) et le quatrième noeud (104),
- un deuxième interrupteur (120) est monté entre le quatrième noeud (104) et le troisième noeud (103),
- un circuit (185) générateur d'impulsions est monté entre le quatrième noeud (101) et le deuxième noeud (102), le circuit (185) générateur d'impulsions comprenant un montage en parallèle d'un condensateur (170) et d'un circuit série composé d'une inductance (160) et d'un commutateur (190),
**caractérisé**
**en ce qu'**entre le troisième noeud (103) et le deuxième noeud (102), une diode (130) de roue libre est montée en série avec un premier absorbeur (140) d'énergie.

2. Disjoncteur (100) de protection de circuit à tension continue suivant la revendication 1, dans lequel le circuit (185) générateur d'impulsions comprend en série avec le circuit en parallèle une résistance (150) et une deuxième diode (195).

3. Disjoncteur (100) de protection de circuit à tension continue suivant l'une des revendications précédentes, dans lequel le circuit (185) générateur d'impulsions comprend en parallèle au circuit parallèle et à la résistance un deuxième absorbeur (180) d'énergie.

4. Disjoncteur (100) de protection de circuit à tension continue suivant l'une des revendications précédentes, dans lequel le premier interrupteur (110) est un sectionneur simple ou un interrupteur à SF6.

5. Disjoncteur (100) de protection de circuit à tension continue suivant l'une des revendications précédentes, dans lequel le deuxième interrupteur (120) est un interrupteur hybride, qui comporte de préférence un interrupteur à vide.
